# EUROPEAN PATENT SPECIFICATION

(11) **EP 3 989 690 B1**
(45) Date of publication and mention of the grant of the patent: **06.08.2025**
(21) Application number: 20848301.6
(22) Date of filing: 22.05.2020
(51) Int. Cl.: H05K 7/20

(54) **COMMUNICATION DEVICE**
KOMMUNIKATIONSVORRICHTUNG
DISPOSITIF DE COMMUNICATION

(30) Priority: 29.07.2019 CN 201910691426
(43) Date of publication of application: 27.04.2022
(73) Proprietor: ZTE Corporation, Shenzhen, Guangdong 518057 (CN)
(72) Inventor: JI, Shengtao, Shenzhen, Guangdong 518057 (CN); GUO, Yulong, Shenzhen, Guangdong 518057 (CN); LI, Shuai, Shenzhen, Guangdong 518057 (CN); LU, Jin, Shenzhen, Guangdong 518057 (CN)
(74) Representative: Savi, Massimiliano
(86) International application number: PCT/CN2020/091924
(87) International publication number: WO 2021/017595

(56) References cited:
- EP-A1- 0 485 281
- EP-A1- 2 999 321
- CN-A- 101 466 251
- CN-A- 103 153 027
- CN-A- 106 953 816
- CN-U- 203 327 455
- US-A1- 2008 055 845
- US-A1- 2011 036 554

## Description

### TECHNICAL FIELD

The present disclosure relates to, but is not limited to, device ventilation technologies, and more specifically, relates to a communication device having an air channel.

### BACKGROUND

With the demand for higher information rates and the advent of the 5G communication era, communication products develop toward integration and high power, and heat dissipation of devices is facing a huge challenge. While the physical number of devices in an operator's server room remains unchanged, the power consumption of the entire server room increases sharply, and the problem of insufficient power supply, cooling and the like in the server room becomes increasingly severe. From the perspective of energy saving and cost saving, the operator renovates the server room and improves the energy efficiency ratio of cooling the server rooms by laying out micro-modules, micro-cooling pools, and other solutions to implement the isolation between cold and hot aisles for devices.

For a communication device with board area configurations of three or more subracks on a single side, in conventional forms such as vertical air channels, transverse air channels, longitudinal air channels, and other forms, there are thermal cascade, high thermal resistance, hot spot concentration, and other problems, making heat dissipation of devices relatively difficult, and leading to limited application scenarios or configurations. For example, in a communication device, air flows in a single direction between a subrack and a side of a rack for an intermediate subrack board area. The wind resistance is high, and heat dissipation is affected. In addition, the intermediate subrack board area discharges hot air toward a rack wall. As a result, hot spots are concentrated, and the rack wall has a relatively high temperature, leading to poor customer perception. In another communication device, air flows through upper and lower subrack board areas for an intermediate subrack board area, and there is a severe thermal cascade in slot areas through which air flows. As a result, the configuration of boards may be limited or fail in upper and lower board areas.

EP0485281A1 discloses a device including a plurality of board areas (2.1-2.4) each including independent air intake channel (5.1-5.4) and air discharge channel (9). Air from all air discharge channels are sucked to the top of the housing (1) via the interlayer air channel (10) for discharging.

EP2999321A1 discloses an air deflection plug-in box for a forced air-cooled cabinet and the forced air-cooled cabinet. The air deflection plug-in box includes a front vertical plate with one or more vent holes, a rear vertical plate with one or more vent holes, two side vertical plates with suspension loops and an air deflection diaphragm arranged to isolate air areas, wherein the front vertical plate, the rear vertical plate, the two side vertical plates and the air deflection diaphragm are fixedly connected into a whole to distinctively guide cold airflow on one side of the air deflection diaphragm and guide hot airflow on the other side of the air deflection diaphragm, one or more thermal barriers are also arranged on at least one surface of the air deflection diaphragm, and each thermal barrier is made from thermal insulation material.

While the above patent applications may achieve their intended purposes, there is still a need for a new and improved a communication device.

### SUMMARY

The following is a summary of the subject matter detailed herein. This summary is not intended to limit the protection scope of the appended claims.

Embodiments of the present disclosure provide a communication device. The communication device includes a shell, a first board area, a second board area and a third board area. The first board area, the second board area and the third board area are sequentially arranged from top to bottom and are each provided with an independent air channel, and an interlayer air channel in communication with the air channel of the second board area is further provided behind the first board area, the second board area and the third board area. Air intake holes of the first board area, the second board area and the third board area are separately provided in a front surface of the shell, the air channel of the first board area comprises a first air channel in communication with the air intake holes of the first board area, the air channel of the second board area comprises a second air channel in communication with the air intake holes of the second board area, the air channel of the third board area comprises a third air channel in communication with the air intake holes of the third board area, and the first air channel, the second air channel and the third air channel are independent of each other. A first air mixing channel located above the first board area and in communication with the first air channel and a second air mixing channel located below the third board area and in communication with the third air channel are provided in the shell; and the second air channel is in communication with the first air mixing channel and the second air mixing channel via the interlayer air channel, and the first air mixing channel and the second air mixing channel are respectively in communication with the system air discharge channel via respective air cooling modules.

By the communication device in the embodiments of the present disclosure, the interlayer air channel is designed, so that the air channel distribution of a system is more appropriate, thereby effectively improving the heat dissipation performance of the communication device.

Other aspects may become comprehensible by reading and understanding the accompanying drawings and the detailed description.

### BRIEF DESCRIPTION OF DRAWINGS

FIG. 1 is a schematic diagram of a front part of a communication device according to an embodiment of the present disclosure.
FIG. 2 is a schematic diagram of an internal structure of the communication device shown in FIG. 1, illustrating parts related to air channels.
FIG. 3A is a schematic diagram of the air channels of the communication device shown in FIG. 1.
FIG. 3B is a schematic diagram of air channels of a communication device in another embodiment.
FIG. 4 is a schematic diagram of a board in a second board area in the communication device shown in FIG. 1.
FIG. 5 is a schematic diagram of a first partition and a second partition in a second board area in the communication device shown in FIG. 1.
FIG. 6 is a schematic diagram of an internal structure of the communication device shown in FIG. 1 with back boards of board areas of the device changed to an integral back board, illustrating parts related to the air channels.
FIG. 7 is a schematic diagram of an internal structure and air channels of a communication device according to another embodiment of the present disclosure.
FIG. 8 is a schematic diagram of a back board in FIG. 7.
FIG. 9 is a schematic diagram of an air channel of a second board area in the communication device shown in FIG. 7.

### DETAILED DESCRIPTION

A plurality of embodiments are described in the present application. However, the description is exemplary and not limiting. It is apparent to a person having ordinary skills in the art that there may be more embodiments and implementations within the scope of the embodiments described in the present application. Although many possible combinations of features are shown in the accompanying drawings and discussed in specific implementations, many other combinations of the disclosed features are possible. Unless intentionally limited, any feature or element in any embodiment may be used in combination with any other feature or element in any other embodiment, or may replace any other feature or element in any other embodiment.

An embodiment of the present disclosure provides a communication device. A plurality of partitions are provided, and structural features such as existing back boards inside the device are combined, to form an interlayer air channel of an intermediate board area, so that an upper board area, the intermediate board area and a lower board area have independent air intake channels and air discharge channels. An air cooling module of a system is provided in a rear area of the device, and air is pumped from the board areas. Air enters from a board in the intermediate board area, dissipates heat from heat source devices, flows to the interlayer air channel, is mixed with high-temperature air flowing through the upper board area and the lower board area, and is then pumped out from the device by the air cooling module in the rear, to complete heat dissipation of the system. Based on the foregoing design, while front-intake rear-discharge air channels of the device is generally implemented, in one aspect, the board areas inside the device have independent air channels, and the airflow distribution and temperature distribution are more uniform inside the device, thereby solving the problems of thermal cascade and hot spot concentration. In another aspect, obstacles in the air channels inside the device are reduced and are controllable, thereby solving the problem of high thermal resistance in the intermediate subrack. In addition, a sound absorbing material may be further provided in the air channels inside the device, to perform noise reduction for the system, and improve the heat dissipation performance of the system.

A communication device in an embodiment of the present disclosure includes a shell, a first board area, a second board area and a third board area, where the first board area, the second board area and the third board area are sequentially arranged from top to bottom and are each provided with an independent air channel, and an interlayer air channel in communication with the air channel of the second board area is further provided behind the first board area, the second board area and the third board area; and air discharged from the air channel of the second board area is guided to at least one of a position above the first board area or a position below the third board area via the interlayer air channel, to be mixed with air discharged from at least one of the air channel of the first board area or the air channel of the third board area, and the mixed air is then discharged via an air cooling module and a system air discharge channel. In an embodiment, the interlayer air channel is configured to guide air discharged from the air channel of the second board area in two separate airflows to the position above the first board area and the position below the third board area, and respectively mix the air of the two airflows with air discharged from the air channel of the first board area and air discharged from the air channel of the third board area. In another embodiment, the interlayer air channel is configured to guide air discharged from the air channel of the second board area to the position above the first board area or the position below the third board area, and mix the air with air discharged from the air channel of the first board area or the air channel of the third board area.

In an embodiment, air intake holes of the first board area, the second board area and the third board area are separately provided in a front surface of the shell, the air channel of the first board area includes a first air channel in communication with the air intake holes of the first board area, the air channel of the second board area includes a second air channel in communication with the air intake holes of the second board area, the air channel of the third board area includes a third air channel in communication with the air intake holes of the third board area, and the first air channel, the second air channel and the third air channel are independent of each other.

In an embodiment, a first air mixing channel located above the first board area and in communication with the first air channel and a second air mixing channel located below the third board area and in communication with the third air channel are provided in the shell; and the second air channel is in communication with the first air mixing channel and the second air mixing channel via the interlayer air channel, and the first air mixing channel and the second air mixing channel are respectively in communication with the system air discharge channel via respective air cooling modules.

In an embodiment, the system air discharge channel is in communication with air discharge holes provided in a rear surface of the shell.

The communication device in the embodiments of the present disclosure may be alternatively a communication device with four or more subracks, and may have four or more board areas. In this case, except one upper first board area and one lower third board area, the remaining board areas are all intermediate second board areas. That is, the second board area may include one board area or a plurality of board areas. When the second board area includes a plurality of board areas, the air channel of the second board area includes air channels of a plurality of board areas. The air channels of the plurality of board areas may be in communication with each other or may be isolated from each other.

In the embodiments of the present disclosure, boards in the first board area, the second board area and the third board area are functional boards for implementing functions such as control, processing and signal transmission, to implement normal service functions of the communication device. A first back board, a second back board, and a third back board are separately circuitry boards provided behind the first board area, the second board area and the third board area, the boards in the board areas are inserted in corresponding back boards for running.

The communication device in the embodiments of the present disclosure has at least one of the characteristic as follows:
the board areas inside the device have independent air channels, and the airflow distribution and temperature distribution are more uniform inside the device, thereby solving the problems of thermal cascade and hot spot concentration; and
obstacles in the air channels inside the device are reduced and are controllable, thereby solving the problem of high thermal resistance in the intermediate subrack.

The air intake holes are provided in the front of the device, and the air discharge holes are provided in the rear of the device, to generally implement front-intake rear-discharge air channels.

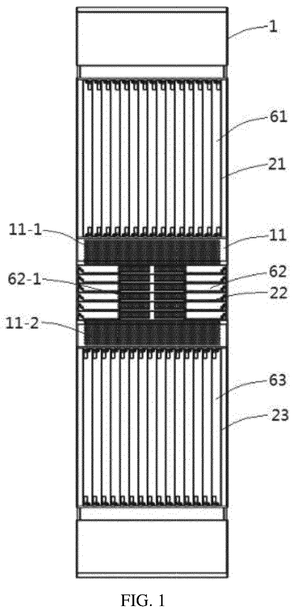

In an embodiment of the present disclosure, as shown in FIGS. 1 to 5, boards in a first board area 21 are longitudinally arranged in parallel. Air intake holes 11-1 of the first board area 21 are provided in a front surface 11 of the shell 1 between the first board area 21 and the second board area 22. The first air channel includes an air intake channel 21-1 formed by the first board area 21, two side wall surfaces of the shell 1 and a first baffle. The first baffle is located below the first board area 21 and isolates the first air channel 21-1 from the second air channel.

Boards in the third board area 23 are longitudinally (a longitudinal direction is a vertical direction) arranged in parallel. Air intake hole 11-2 of the third board area 23 are provided in a front surface 11 of the shell 1 between the third board area 23 and the second board area 22. The third air channel includes an air intake channel 23-1 formed by the third board area 23, the two side wall surfaces of the shell 1 and a second baffle. The second baffle is located above the third board area 23 and isolates the third air channel from the second air channel. In an embodiment shown in FIGS. 1 to 5, the first baffle is a front-low rear-high first air guide plate 51, and the second baffle is a front-high rear-low second air guide plate 52. However, the present application is not limited thereto. The first baffle and the second baffle may both be horizontally arranged.

Boards in the second board area 22 are transversely (a transverse direction is a horizontal direction) arranged in parallel. Air intake holes 62-1 of the second board area 22 are provided in a board 62 of the second board area 22. The second air channel includes a ventilation channel formed by the second board area 22, the wall surfaces of the shell 1, a third baffle and a fourth baffle. The third baffle is located above the second board area 22 and isolates the second air channel from the first air channel. The fourth baffle is located below the second board area 22 and isolates the second air channel from the third air channel. The third baffle and the foregoing first baffle may be the same baffle or may be different baffles. The fourth baffle and the foregoing second baffle may be the same baffle or may be different baffles. Two air channels may be isolated by one or more baffles.

Two structures of the second board area 22 are described below by using two embodiments.

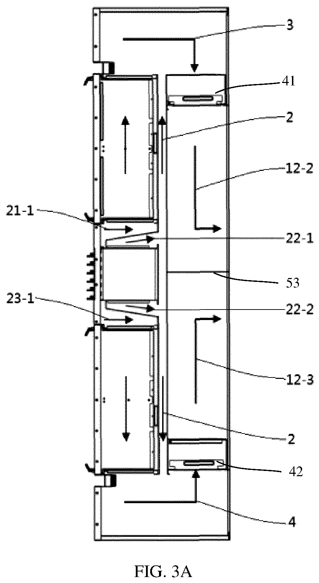

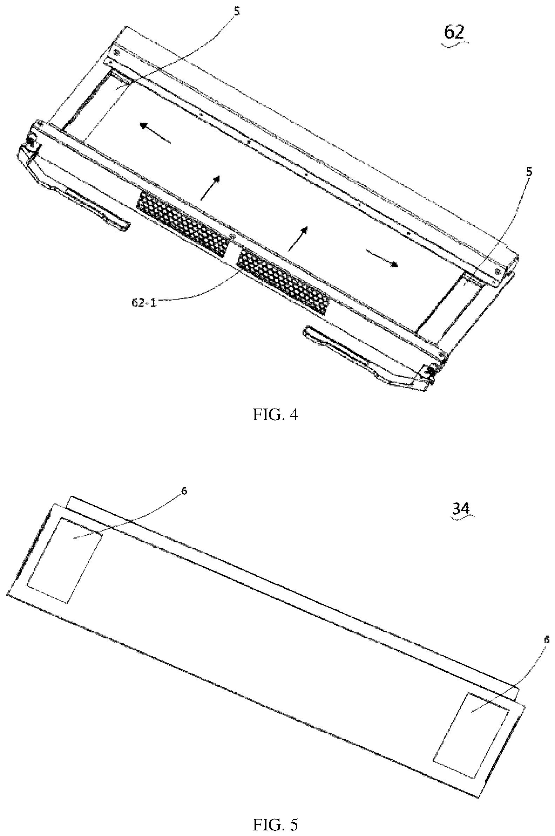

In an embodiment shown in FIGS. 1 to 5, the air intake holes 62-1 of the second board area 22 are provided in the middle of the board 62 of the second board area 22. The third baffle is a front-low rear-high first air guide plate 51, and the fourth baffle is a front-high rear-low second air guide plate 52. Ventilation spaces are provided at two sides of the second board area 22. A first partition 34 is provided at a top of the second board area 22. A second partition 35 is provided at the bottom. As shown in FIG. 5, ventilation holes 6 are provided on two sides of the first partition 34 and the second partition 35. In an embodiment, as shown in FIG. 4, the ventilation spaces at the two sides of the second board area 22 are in communication with each other via ventilation holes 5 opened on two sides of printed circuit boards in the second board area 22. In an embodiment, as shown in FIG. 3A, the second air channel of the foregoing structure includes an upper air discharge channel 22-1 and a lower air discharge channel 22-2. "Upper" and "lower" refer to a relative position relationship between the air discharge channel 22-1 and the air discharge channel 22-2.

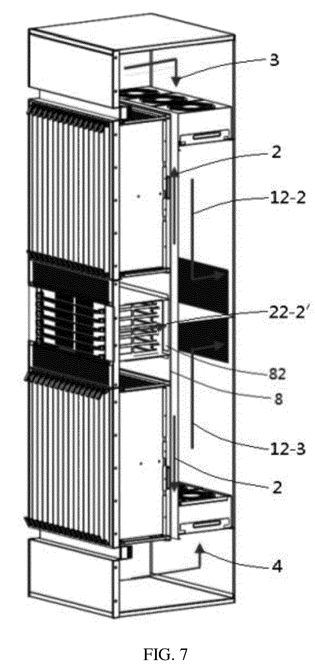

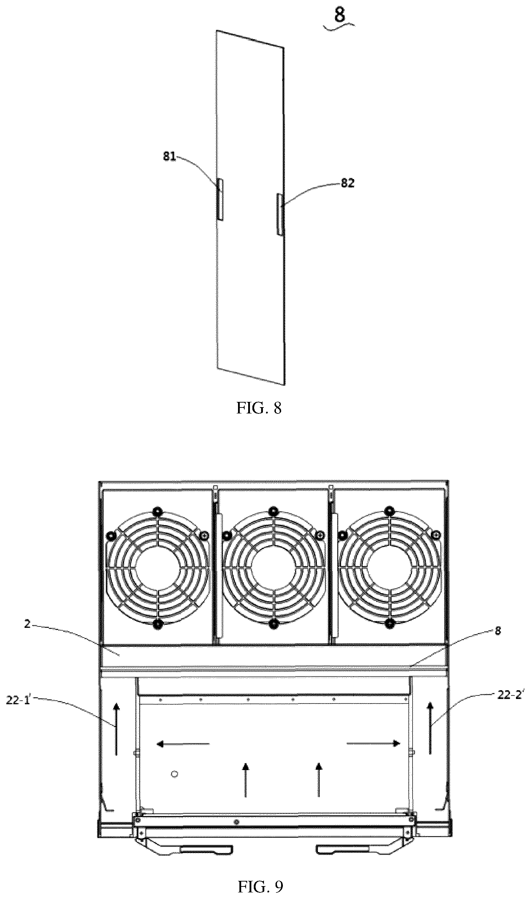

In another embodiment shown in FIGS. 7 to 9, a back board 8 is one integral back board. The air intake holes 62-1 of the second board area 22 are provided in the middle of the board of the second board area 22. The third baffle is the first partition 34 at a top of the second board area 22. The fourth baffle is the second partition 35 at a bottom of the second board area 22. Ventilation spaces are provided between two sides of the second board area 22 and two side wall surfaces of the shell 1. As shown in FIG. 8, two ventilation holes 82 are provided at two sides of the back board 8 of the second board area 22 corresponding to the two ventilation spaces, to implement communication between the second air channel and the interlayer air channel 2. In an embodiment, the second air channel includes a left air discharge channel 22-1' and a right air discharge channel 22-2'.

The interlayer air channel 2 and the second air channel may be in communication in a plurality of manners.

In the embodiment shown in FIGS. 1 to 5, the back boards of the first board area 21, the second board area 22 and the third board area 23 are separately provided. The interlayer air channel 2 is formed by a first back board 31 of the first board area 21, a second back board 32 of the second board area 22, a third back board 33 of the third board area 23, a third partition 36 provided behind these back boards, and two side wall surfaces of the shell 1. The second air channel includes the upper air discharge channel 22-1 and the lower air discharge channel 22-2. In an embodiment, the interlayer air channel 2 and the second air channel are in communication through gaps between different back boards.

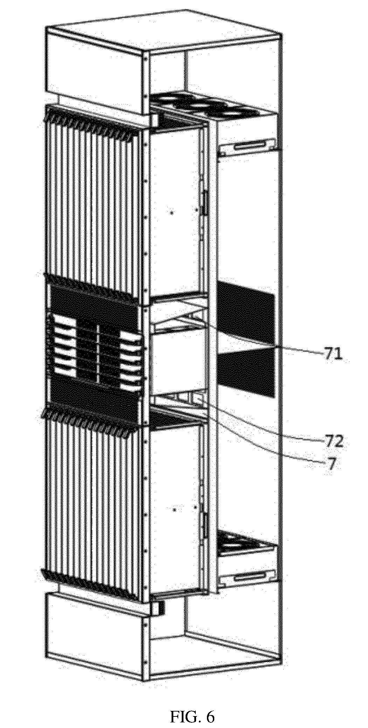

In the embodiment shown in FIG. 6, the back boards of the first board area 21, the second board area 22 and the third board area 23 are one integral back board 7. The second air channel includes the upper air discharge channel 22-1 and the lower air discharge channel 22-2. In this case, the interlayer air channel 2 and the second air channel are in communication through a ventilation hole 71 corresponding to the upper air discharge channel 22-1 and a ventilation hole 72 corresponding to the lower air discharge channel 22-2 in the back board 7.

In the embodiment shown in FIGS. 7 to 9, the back boards of the first board area 21, the second board area 22 and the third board area 23 are one integral back board 8. The second air channel includes the left air discharge channel 22-1' and the right air discharge channel 22-2'. A ventilation hole 81 is opened at a position corresponding to the left air discharge channel 22-1' in the integral back board 8. A ventilation hole 82 is opened at a position corresponding to the right air discharge channel 22-2'.

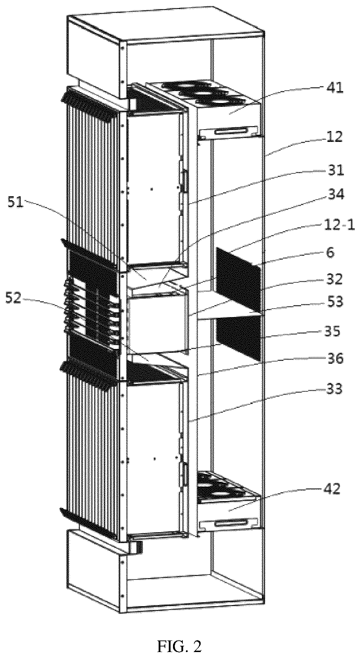

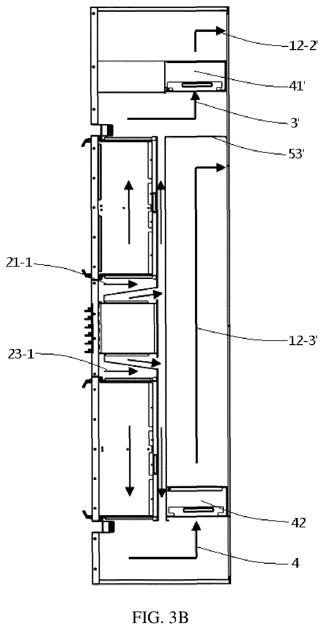

As shown in FIGS. 2 and 3A, the air cooling module includes a first air cooling module 41 provided on an upper portion behind the interlayer air channel 2 and a second air cooling module 42 provided on a lower portion behind the interlayer air channel 2. The system air discharge channel is located behind the interlayer air channel and between the first air cooling module 41 and the second air cooling module 42, and is separated by a third air guide plate 53 into a first air discharge channel 12-2 and a second air discharge channel 12-3. The first air discharge channel 12-2 and the second air discharge channel 12-3 are each in communication with the outside via respective air discharge holes 12-1 in a rear surface 12 of the shell 1. The second air mixing channel 4 is also an air discharge channel of the third board area 23. A first air mixing channel 3 is also an air discharge channel of the first board area 21. In another embodiment shown in FIG. 3B, the air cooling module includes a first air cooling module 41' provided above the first air mixing channel 3 and a second air cooling module 42' provided on a lower portion behind the interlayer air channel 2. The system air discharge channel includes a first air discharge channel 12-2' located above the first air cooling module 41' and a second air discharge channel 12-3' located behind the interlayer air channel 2. The second air discharge channel 12-3' and the first air mixing channel 3 are separated by a third air guide plate 53'. The first air discharge channel 12-2' and the second air discharge channel 12-3' are in communication with the outside via respective air discharge holes 12-1 in the rear surface 12 of the shell 1.

A sound absorbing material is provided on a wall surface of at least one of the first air mixing channel 3, the second air mixing channel 4 or the system air discharge channel in the foregoing embodiment, to eliminate as much noise as possible.

In the foregoing embodiment, the first partition 34 and the second partition 35 may have the same structural features, are respectively tightly attached to upper and lower surfaces of the second board area 22, and are in mirror symmetry with respect to the second board area 22. The third partition 36 is separated by a distance from the first back board 31, the second back board 32 and the third back board 33, to form the interlayer air channel 2. The third partition 36 is separated by a distance from the rear surface 12 of the shell 1. The first air cooling module 41 is provided between an upper portion of the third partition 36 and the rear surface 12 of the shell 1. The position of the first air cooling module may be adjusted as required. The second air cooling module 42 is provided between a lower portion of the third partition 36 and the rear surface 12 of the shell 1. The position of the second air cooling module 42 may be adjusted as required. The third air guide plate 53 is provided between a middle position of the third partition 36 and the rear surface 12 of the shell 1. The first air discharge channel 12-2 of the system is formed between the third air guide plate 53, a part of the third partition 36 above the third air guide plate 53, the wall surfaces of the shell 1, and the rear surface 12 of the shell 1. The second air discharge channel 12-3 of the system is formed between the third air guide plate 53, a part of the third partition 36 below the third air guide plate 53, the wall surfaces of the shell 1, and the rear surface 12 of the shell 1.

In the foregoing embodiment, the first board area 21 is separated by a distance from an inner surface of a top of the shell 1. An upper portion of the first board area 21, an upper portion of the first air cooling module 41 and the shell 1 form the first air mixing channel 3. The first air guide plate 51 is provided between the first board area 21 and the first partition 34 at an upper portion of the second board area 22. The first air guide plate 51 is separated by a distance from the first board area 21. The first air guide plate 51, the first board area 21 and left and right sidewalls of the shell 1 form the air intake channel 21-1 of the first board area 21.

In the foregoing embodiment, the air intake holes 62-1 are provided in the middle of the board of the second board area 22, to form the air intake channel of the second board area 22. In the embodiment shown in FIGS. 1 to 6, the ventilation holes 5 of a ventilation area are respectively provided on the left and right of the boards (PCBs) in the second board area 22. The ventilation holes 6 of close sizes are provided at positions corresponding to the ventilation holes 5 for the boards (PCBs) in the second board area 22 in the first partition 34 and the second partition 35. The ventilation holes 6 provided in the first partition 34 and the second partition 35 are air discharge holes in the second board area 22. The first air guide plate 51 is separated by a distance from the first partition 34 at the upper portion of the second board area 22. The first air discharge channel 22-1 of the second board area 22 is formed between the first air guide plate 51, the first partition 34, and the left and right wall surfaces of the shell 1, the first air discharge channel 22-1 is in communication with the interlayer air channel 2 through a gap between the first back board 31 and the second back board 32. A second air guide plate 52 is provided between the second partition 35 of the second board area 22 and the third board area 23. The second partition 35 is separated by a distance from the second air guide plate 52. A second air discharge channel 22-2 of the second board area 22 is formed between the second partition 35, the second air guide plate 52, and the left and right wall surfaces of the shell 1, the second air discharge channel 22-2 is in communication with the interlayer air channel 2.

In the foregoing embodiment, the second air guide plate 52 is separated by a distance from the third board area 23. The second air guide plate 52, the third board area 23, and the wall surfaces on the left and right sides of the shell 1 form the air intake channel 23-1 of the third board area 23.

In the foregoing embodiment, the third board area 23 is separated by a distance from an inner surface of a bottom of the shell 1. A lower portion of the third board area 23, a lower portion of the second air cooling module 42, and an inner surface of the shell 1 form the second air mixing channel 4.

During operation of the device, air in the system enters the air intake channels of the first board area, the second board area and the third board area through the air intake holes in the front surface of the shell, flows through heat consuming devices on boards in corresponding board areas, dissipates heat from the heat consuming devices, and flows to air discharge channels of the corresponding board areas. High-temperature air from the air discharge channel of the first board area and high-temperature air that is from the second board area and enters the interlayer air channel to flow upward are mixed together in the first air mixing channel, and are pumped by the first air cooling module to the first air discharge channel of the system. High-temperature air from an air discharge channel of the third board area and high-temperature air that is from the second board area and enters the interlayer air channel to flow downward are mixed together in the second air mixing channel, and are pumped by the second air cooling module to the second air discharge channel of the system. High-temperature air that flows through the first air discharge channel and the second air discharge channel of the system flows out of the device through the air discharge holes in the rear surface of the shell. The whole process implements the heat dissipation of the system.

In the foregoing embodiment, a sound absorbing material may be further provided on wall surfaces of the air channels such as the first air mixing channel, the second air mixing channel, the first air discharge channel and the second air discharge channel, to perform noise reduction on the air channels inside the system, and improve the heat dissipation performance of the system.

The communication device in the embodiments of the present disclosure has at least one of the following effects.

The interlayer air channel is designed, so that the air channel distribution of the system is more appropriate, the heat dissipation of the system can be effectively improved, thereby solving heat dissipation problems such as thermal cascade, high wind resistance and high local airflow temperature of the device.

Front air intake and rear air discharge can be generally implemented, device layout requirements of isolating cold and hot air channels in server rooms of operators are satisfied, and an integral structure of subrack and rack is not needed.

By the communication device in the embodiments of the present disclosure, air channels are appropriately designed, the heat dissipation performance of the system can be improved for subsequent extension and upgrade of products.

The embodiments in FIGS. 1 to 9 are further described below in detail.

Referring to FIGS. 1 to 5, the communication device includes the shell 1, the first board area 21, the second board area 22, the third board area 23, the first back board 31, the second back board 32, the third back board 33, the first partition 34, the second partition 35, the third partition 36, the first air cooling module 41, the second air cooling module 42, the first air guide plate 51, the second air guide plate 52 and the third air guide plate 53.

Ventilation holes 11-1 (that is, the foregoing air intake holes 11-1) and ventilation holes 11-2 (that is, the foregoing air intake holes 11-2) are provided in the front surface 11 of the shell 1. Ventilation holes 12-1 (that is, the foregoing air discharge holes 12-1) are provided in the rear surface 12. The ventilation holes 11-1 and 11-2 are air intake areas of the communication device. The ventilation holes 12-1 are an air discharge area of the communication device.

A series of boards 61 longitudinally arranged in parallel are provided in the first board area 21. Boards 62 transversely arranged in parallel are provided in the second board area 22. Boards 63 that are longitudinally arranged in parallel are provided in the third board area 23.

The first back board 31, the second back board 32 and the third back board 33 are respectively circuitry boards of the boards in the first board area 21, the second board area 22 and the third board area 23, to implement functions such as signal and circuit communication between the boards. The boards 61 in the first board area 21, the boards 62 in the second board area 22 and the boards 63 in the third board area 23 are respectively inserted in the corresponding first back board 31, second back board 32 and third back board 33 for running. An insulating, thermally isolating material may be provided on rear surfaces of the back boards corresponding to the board areas, to implement protection for the first back board 31, the second back board 32 and the third back board 33.

The third partition 36 is provided at an airflow channel distance from the first back board 31, the second back board 32 and the third back board 33, to form the interlayer air channel 2. The third partition 36 is separated by a distance from the rear surface 12 of the shell 1. The first air cooling module 41 is provided between the upper portion of the third partition 36 and the rear surface 12 of the shell 1. The second air cooling module 42 is provided between the lower portion of the third partition 36 and the rear surface 12 of the shell 1. The third air guide plate 53 is provided between the middle position of the third partition 36 and the rear surface 12 of the shell 1, to separate the space between the third partition 36 and a rear wall of the shell 1. The first air discharge channel 12-2 of the system is formed between the position above the middle of the third partition 36 and the rear surface 12 of the shell 1. The second air discharge channel 12-3 of the system is formed between the position below the middle of the third partition 36 and the rear surface 12 of the shell 1.

The first board area 21 is placed with respect to an upper portion of the shell 1. The first board area 21 is separated by a distance from an inner surface of the upper portion of the shell 1. A space defined by the upper portion of the first board area 21, the upper portion of the first air cooling module 41 and the wall surfaces of the shell 1 forms the first air mixing channel 3.

The second board area 22 is placed with respect to a middle portion of the shell 1. The first partition 34 and the second partition 35 of the same features are respectively provided above and below the second board area. The first partition 34 and the second partition 35 are in mirror symmetry with respect to the second board area 22. The first air guide plate 51 is provided between the first partition 34 and the first board area 21. The second air guide plate 52 is provided between the second partition 35 and the third board area 23.

Ventilation holes 62-1 are provided in the boards 62 in the second board area 22, to serve as the air intake holes in the second board area. The ventilation holes 5 of a ventilation area are respectively provided on the left and right of the boards (PCBs) 62. The ventilation holes 6 of close sizes are provided at positions corresponding to the ventilation holes for the boards (PCBs) 62 in the first partition 34 and the second partition 35, to serve as air discharge holes in the second board area.

The first board area 21 is separated by a distance from the first air guide plate 51. The first board area 21, the first air guide plate 51 and the wall surfaces of the shell 1 form the air intake channel 21-1 of the first board area 21.

The first partition 34 in the second board area 22 is separated by a distance from the first air guide plate 51. The first air discharge channel 22-1 of the second board area 22 is formed between the first partition 34, the first air guide plate 51 and the wall surfaces of the shell 1, the first air discharge channel 22-1 is in communication with the interlayer air channel 2.

The second partition 35 in the second board area 22 is separated by a distance from the second air guide plate 52. The second air discharge channel 22-2 of the second board area 22 is formed between the second partition 35, the second air guide plate 52 and the wall surfaces of the shell 1, the which second air discharge channel 22-2 is in communication with the interlayer air channel 2.

The third board area 23 is separated by a distance from the second air guide plate 52. The third board area 23, the second air guide plate and the wall surfaces of the shell 1 form the air intake channel 23-1 of the third board area 23.

The third board area 23 is separated by a distance from an inner surface of the bottom of the shell 1. A space defined by the lower portion of the third board area 23, the lower portion of the second air cooling module 42 and the wall surfaces of the shell 1 forms the second air mixing channel 4.

Air in the system enters the air intake channel 21-1 of the first board area 21 through the ventilation holes 11-1 in the front surface 11 of the shell 1, and flows through heat source devices of the boards 61 in the first board area 21, to carry heat to the first air mixing channel 3.

Air in the system enters the air intake channel 23-2 of the third board area 23 through the ventilation holes 11-1 in the front surface 11 of the shell 1, and flows through heat source devices of the boards 63 in the third board area 23, to carry heat to the second air mixing channel 4.

Air in the system enters the second board area 22 through the ventilation holes 62-1 in the boards 62 in the second board area 22, flows through heat source devices of the boards 62, carries heat upward to the first air discharge channel 22-1 of the second board area 22, then enters the interlayer air channel 2, and then flows upward to enter the first air mixing channel 3. High-temperature air from the first board area 21 and high-temperature air from the second board area 22 are mixed together in the first air mixing channel 3, and are pumped by the first air cooling module 41 to the first air discharge channel 12-2 of the system.

Air in the system enters the second board area 22 through the ventilation holes 62-1 in the boards 62 in the second board area 22, flows through the heat source devices of the boards 62, carries heat downward to the second air discharge channel 22-2 of the second board area 22, then enters the interlayer air channel 2, and flows downward to enter the second air mixing channel 4. High-temperature air from the third board area 23 and high-temperature air from the second board area 22 are mixed together in the second air mixing channel 4, and are pumped by the second air cooling module 42 to the second air discharge channel 12-3 of the system.

High-temperature air that flows through the first air discharge channel 12-2 of the system and high-temperature air that flows through the second air discharge channel 12-3 of the system flow out of the device through the ventilation holes 12-1 in the rear surface 12 of the shell 1. The whole process implements the heat dissipation of the system.

A sound absorbing material may be provided at positions such as wall surfaces of the first air mixing channel 3, the second air mixing channel 4, the first air discharge channel 12-2 of the system and the second air discharge channel 12-3 of the system, to implement a noise reduction design on airflow channels inside the system,

The foregoing first back board 31, second back board 32 and third back board 33 have a separate form, or may be an integral back board 7 (referring to FIG. 6). The ventilation hole 71 is provided corresponding to a position between the first board area 21 and the second board area 22 in the integral back board 7. The ventilation hole 72 is provided corresponding to a position between the third board area 23 and the second board area 22 in the integral back board 7. The first air discharge channel 22-1 and the second air discharge channel 22-2 of the second board area 22 are respectively in communication with the interlayer air channel 2 through the ventilation hole 71 and the ventilation hole 72. The forms of the air channels are consistent with those above.

FIGS. 7 to 9 show a second implementation according to the present disclosure. The system architecture and most air channel forms are consistent with those in the foregoing first implementation. Differences lie in the foregoing second board area 22 and the air channel forms thereof.

The first back board 31, the second back board 32 and the third back board 33 are changed into the integral back board 8. The ventilation holes 5 are canceled for the boards (PCBs) 62 of the second board area 22. The ventilation holes 6 are canceled for the first partition 34 and the second partition 35.

A left side and a right side of the second board area 22 are respectively separated by a distance from the left side and the right side of the shell 1. The ventilation hole 81 and the ventilation hole 82 of the same size are opened on the left and right corresponding to the second board area 22 in the integral back board 8.

A first air discharge channel 22-1' of the second board area 22 is formed between the left side of the second board area 22, the left sidewall of the shell 1, the first partition 34 and the second partition 35, the first air discharge channel 22-1' is in communication with the interlayer air channel 2 through the ventilation hole 81.

A second air discharge channel 22-2' of the second board area 22 is formed between the right side of the second board area 22, the right sidewall of the shell 1, the first partition 34 and the second partition 35, the second air discharge channel 22-2' is in communication with the interlayer air channel 2 through the ventilation hole 82.

Air in the system enters the second board area 22 through the ventilation holes 62-1 in the boards 62 in the second board area 22, flows through the heat source devices of the boards 62, respectively carries heat to the left and right to the first air discharge channel 22-1' and the second air discharge channel 22-2' of the second board area 22, then flows through the ventilation holes 81 and 82 of the integral back board 8, enters the interlayer air channel 2, and flows upward and downward to respectively enter the first air mixing channel 3 and the second air mixing channel 4 to be mixed with high-temperature air from the first board area 21 and high-temperature air from the third board area 23. Air in the two airflows is respectively pumped by the first air cooling module 41 and the second air cooling module 42 to the first air discharge channel 12-2 of the system and the second air discharge channel 12-3 of the system.

High-temperature air that flows through the first air discharge channel 12-2 of the system and high-temperature air that flows through the second air discharge channel 12-3 of the system pass through the ventilation holes 12-1 in the rear surface 12 of the shell 1 and flow out of the device. The whole process implements the heat dissipation of the system.

By the communication device of the present disclosure, appropriate air channel designs and noise reduction measures are adopted, so that problems such as thermal cascade, high wind resistance and high local airflow temperature are solved, and the form of front-intake rear-discharge air channels of the device is implemented. According to estimation, the slot heat dissipation capability can be increased by approximately 40%.

In the description of the present application, the terms "mounted", "connected", "connection", and "fastened" should all be understood in a broad sense. For example, "connected" may be fixedly connected, detachably connected, or integrally connected; or connected directly or through an intermediate. For a person having ordinary skills in the art, specific meanings of the terms in the present disclosure should be understood according to specific conditions. In the description of the specification, the description with reference to terms "an embodiment", "some embodiments", "specific embodiments" and the like indicate that specific features, structures, materials or characteristics described with reference to the embodiments or examples are included in at least one embodiment or example of the present application. In this specification, "front", "back", "top", "bottom", "left" and "right" are described based on the orientation of the device. In the specification, the schematic descriptions of the foregoing terms do not necessarily refer to the same embodiments or examples. In addition, the described specific features, structures, materials or characteristics may be combined in an appropriate manner in any one or more embodiments or examples. Although the implementations disclosed in the present application are as described above, the content of the present application is only for the purpose of understanding the implementations of the present application and is not intended to limit the present application. Any person having ordinary skills in the art of the present application may make any modification or change in the form and details of the implementation without departing from the gist and the scope disclosed in the present application. However, the patent protection scope of the present application shall be subject to the scope defined in the appended claims.

## Claims

1. A communication device comprising a shell (1), the shell including:
a first board area (21), a second board area (22) and a third board area (23), wherein the first board area (21), the second board area (22) and the third board area (23) are sequentially arranged in the shell (1) from top to bottom and are each provided with an independent air channel;
an interlayer air channel (2) in communication with the air channel of the second board area (22), wherein the interlayer air channel (2) is provided behind the first board area (21), the second board area (22) and the third board area (23);
air intake holes (11-1, 11-2, 62-1) separately provided in a front surface (11) of the shell (1) for the first board area (21), the second board area (22) and the third board area (23), wherein the air channel of the first board area (21) comprises a first air channel (21-1) in communication with the air intake holes (11-1) of the first board area (21), the air channel of the second board area (22) comprises a second air channel (22-1, 22-2) in communication with the air intake holes (62-1) of the second board area (22), the air channel of the third board area (23) comprises a third air channel (23-1) in communication with the air intake holes (11-2) of the third board area (23), and the first air channel, the second air channel and the third air channel are independent of each other;
a first air mixing channel (3, 3') located above the first board area (21) and in communication with the first air channel (21-1); wherein the second air channel (22-1, 22-2) is in communication with the first air mixing channel (3, 3') via the interlayer air channel (2), and
wherein the first air mixing channel (3, 3') is in communication with a system air discharge channel (12-2, 12-2') via a first air cooling module (41, 41')
**characterized in that**
a second air mixing channel (4) is provided in the shell (1) below the third board area (23) and in communication with the third air channel (23-1);
the second air channel (22-1, 22-2) is in communication with the second air mixing channel (4) via the interlayer air channel (2), wherein the interlayer air channel (2) is configured to guide air discharged from the second air channel (22-1, 22-2) of the second board area (22) in two separate airflows (22-1, 22-2) to the first air mixing channel (3) above the first board area (21) and the second air mixing channel (4) below the third board area (23); and
the second air mixing channel (4) is in communication with the system air discharge channel (12-3, 12-3') via a second air cooling module (42, 42').

2. The communication device of claim 1, wherein
boards (61) in the first board area (21) are longitudinally arranged in parallel, the air intake holes (11-1) of the first board area (21) are provided in the front surface (11) of the shell (1) between the first board area (21) and the second board area (22), the first air channel comprises an air intake channel (21-1) formed by the first board area (21), two side wall surfaces of the shell (1), and a first baffle, and the first baffle is located below the first board area (21) and isolates the first air channel from the second air channel; and
boards (63) in the third board area (23) are longitudinally arranged in parallel, the air intake holes (11-2) of the third board area (23) are provided in the front surface (11) of the shell (1) between the third board area (23) and the second board area (22), the third air channel comprises an air intake channel (23-1) formed by the third board area (23), the two side wall surfaces of the shell (1), and a second baffle, and the second baffle is located above the third board area (23) and isolates the third air channel from the second air channel.

3. The communication device of claim 1, wherein
the air intake holes (62-1) of the second board area (22) are provided in a board (62) of the second board area (22), the second air channel comprises a ventilation channel formed by the second board area (22), wall surfaces of the shell (1), a third baffle, and a fourth baffle; and the third baffle is located above the second board area (22) and isolates the second air channel from the first air channel, and the fourth baffle is located below the second board area (22) and isolates the second air channel from the third air channel.

4. The communication device of claim 3, wherein
boards (62) in the second board area (22) are transversely arranged in parallel, the air intake holes (62-1) of the second board area (22) are provided in a middle of the board (62) of the second board area (22), ventilation spaces are provided at two sides of the second board area (22), a first partition (34) is provided at a top of the second board area (22), a second partition (35) is provided at a bottom of the second board area (22), each of the first partition (34) and the second partition (35) is provided with ventilation holes (6) at two sides corresponding to the ventilation spaces, the first partition (34), the third baffle and the wall surfaces of the shell (1) form an air discharge channel (21-1) of the second air channel, and the second partition (35), the fourth baffle and the wall surfaces of the shell (1) form another air discharge channel (21-2) of the second air channel.

5. The communication device of claim 4, wherein
the ventilation spaces at the two sides of the second board area (22) are in communication via ventilation holes (5) opened on two sides of the boards (62) in the second board area (22).

6. The communication device of claim 3, wherein
boards (62) in the second board area (22) are transversely arranged in parallel, the air intake holes (62-1) of the second board area (22) are provided in a middle of the board (62) of the second board area (22), the third baffle is the first partition (34) at the top of the second board area (22), the fourth baffle is the second partition (35) at the bottom of the second board area (22), ventilation spaces are provided between each of two sides of the second board area (22) and a respective one of the two side wall surfaces of the shell (1), and two ventilation holes (82) are provided at two sides of a back board (8) of the second board area (22) corresponding to the two ventilation spaces.

7. The communication device of claim 1, wherein
the interlayer air channel (2) is formed by back boards (31, 32, 33) of the first board area (21), the second board area (22) and the third board area (23), a third partition (36) provided behind the back boards (31, 32, 33), and two side wall surfaces of the shell (1); and
the back boards (31, 32, 33) of the first board area (21), the second board area (22) and the third board area (23) are provided separately, and the interlayer air channel (2) and the second air channel are in communication with each other through gaps between different back boards (31, 32, 33); or the back boards of the first board area (21), the second board area (22) and the third board area (23) are one integral back board (7), and the interlayer air channel (2) and the second air channel are in communication with each other via a through hole (71, 72) opened in the integral back board (7).

8. The communication device of claim 1, wherein
the first air cooling module (41) is provided on an upper portion behind the interlayer air channel (2) and the second air cooling module (42) is provided on a lower portion behind the interlayer air channel (2), and the system air discharge channel (12-2, 12-3) is located behind the interlayer air channel (2) and between the first air cooling module (41) and the second air cooling module (42), and is separated by an air guide plate (53) into a first air discharge channel (12-2) and a second air discharge channel (12-3); or
the first air cooling module (41') is provided above the first air mixing channel (3) and the second air cooling module (42') is provided on a lower portion behind the interlayer air channel (2), the system air discharge channel (12-2', 12-3') comprises a first air discharge channel (12-2') located above the first air cooling module (41') and a second air discharge channel (12-3') located behind the interlayer air channel (2), and the second air discharge channel (12-3') and the first air mixing channel (3) are separated by an air guide plate (53').

9. The communication device of claim 8, wherein
the first air discharge channel (12-2, 12-2') and the second air discharge channel (12-3, 12-3') are each in communication with the outside via respective air discharge holes (12-1) in a rear surface of the shell (1).

10. The communication device of claim 1, wherein
the second board area (22) in a middle of the device comprises one board area; or
the second board area (22) in the middle of the device comprises a plurality of board areas, and air channels of the plurality of board areas are in communication with each other or separated from each other.

11. The communication device of claim 1, wherein
a sound absorbing material is provided on a wall surface of at least one of the first air mixing channel (3), the second air mixing channel (4) or the system air discharge channel (12-2, 12-3, 12-2', 12-3').

## Patentansprüche

1. Kommunikationsvorrichtung, die ein Gehäuse (1) umfasst, wobei das Gehäuse umfasst:
einen ersten Platinenbereich (21), einen zweiten Platinenbereich (22) und einen dritten Platinenbereich (23), wobei der erste Platinenbereich (21), der zweite Platinenbereich (22) und der dritte Platinenbereich (23) von oben nach unten nacheinander in dem Gehäuse (1) angeordnet sind und jeweils mit einem unabhängigen Luftkanal versehen sind;
einen Zwischenschicht-Luftkanal (2) in Verbindung mit dem Luftkanal des zweiten Platinenbereichs (22), wobei der Zwischenschicht-Luftkanal (2) hinter dem ersten Platinenbereich (21), dem zweiten Platinenbereich (22) und dem dritten Platinenbereich (23) vorgesehen ist;
Lufteinlasslöcher (11-1, 11-2, 62-1), die separat in einer Vorderfläche (11) des Gehäuses (1) für den ersten Platinenbereich (21), den zweiten Platinenbereich (22) und den dritten Platinenbereich (23) vorgesehen sind, wobei der Luftkanal des ersten Platinenbereichs (21) einen ersten Luftkanal (21-1) umfasst, der mit den Lufteinlasslöchern (11-1) des ersten Platinenbereichs (21) in Verbindung steht, der Luftkanal des zweiten Platinenbereichs (22) einen zweiten Luftkanal (22-1, 22-2) umfasst, der mit den Lufteinlasslöchern (62-1) des zweiten Platinenbereichs (22) in Verbindung steht, der Luftkanal des dritten Platinenbereichs (23) einen dritten Luftkanal (23-1) umfasst, der mit den Lufteinlasslöchern (11-2) des dritten Platinenbereichs (23) in Verbindung steht, und der erste Luftkanal, der zweite Luftkanal und der dritte Luftkanal voneinander unabhängig sind;
einen ersten Luftmischkanal (3, 3'), der sich oberhalb des ersten Platinenbereichs (21) befindet und mit dem ersten Luftkanal (21-1) in Verbindung steht; wobei der zweite Luftkanal (22-1, 22-2) über den Zwischenschicht-Luftkanal (2) mit dem ersten Luftmischkanal (3, 3') in Verbindung steht, und
wobei der erste Luftmischkanal (3, 3') über ein erstes Luftkühlmodul (41, 41') mit einem Systemluftablasskanal (12-2, 12-2') in Verbindung steht,
**dadurch gekennzeichnet, dass**
ein zweiter Luftmischkanal (4) in dem Gehäuse (1) unterhalb des dritten Platinenbereichs (23) vorgesehen ist und mit dem dritten Luftkanal (23-1) in Verbindung steht;
der zweite Luftkanal (22-1, 22-2) über den Zwischenschicht-Luftkanal (2) mit dem zweiten Luftmischkanal (4) in Verbindung steht, wobei der Zwischenschicht-Luftkanal (2) dazu ausgelegt ist, aus dem zweiten Luftkanal (22-1, 22-2) des zweiten Platinenbereichs (22) abgelassene Luft in zwei separaten Luftströmen (22-1, 22-2) zu dem ersten Luftmischkanal (3) oberhalb des ersten Platinenbereichs (21) und zu dem zweiten Luftmischkanal (4) unterhalb des dritten Platinenbereichs (23) zu leiten; und
der zweite Luftmischkanal (4) über ein zweites Luftkühlmodul (42, 42') mit dem Systemluftablasskanal (12-3, 12-3') in Verbindung steht.

2. Kommunikationsvorrichtung nach Anspruch 1, wobei
die Platinen (61) in dem ersten Platinenbereich (21) in Längsrichtung parallel angeordnet sind, die Lufteinlasslöcher (11-1) des ersten Platinenbereichs (21) in der Vorderfläche (11) des Gehäuses (1) zwischen dem ersten Platinenbereich (21) und dem zweiten Platinenbereich (22) vorgesehen sind, der erste Luftkanal einen durch den ersten Platinenbereich (21), zwei Seitenwandflächen des Gehäuses (1) und eine erste Ablenkplatte gebildeten Lufteinlasskanal (21-1) umfasst, und die erste Ablenkplatte sich unterhalb des ersten Platinenbereichs (21) befindet und den ersten Luftkanal von dem zweiten Luftkanal trennt; und
die Platinen (63) in dem dritten Platinenbereich (23) in Längsrichtung parallel angeordnet sind, die Lufteinlasslöcher (11-2) des dritten Platinenbereichs (23) in der Vorderfläche (11) des Gehäuses (1) zwischen dem dritten Platinenbereich (23) und dem zweiten Platinenbereich (22) vorgesehen sind, der dritte Luftkanal einen durch den dritten Platinenbereich (23), die zwei Seitenwandflächen des Gehäuses (1) und eine zweite Ablenkplatte gebildeten Lufteinlasskanal (23-1) umfasst, und die zweite Ablenkplatte sich oberhalb des dritten Platinenbereichs (23) befindet und den dritten Luftkanal von dem zweiten Luftkanal trennt.

3. Kommunikationsvorrichtung nach Anspruch 1, wobei
die Lufteinlasslöcher (62-1) des zweiten Platinenbereichs (22) in einer Platine (62) des zweiten Platinenbereichs (22) vorgesehen sind, der zweite Luftkanal einen durch den zweiten Platinenbereich (22), Wandflächen des Gehäuses (1), eine dritte Ablenkplatte und eine vierte Ablenkplatte gebildeten Belüftungskanal umfasst, und die dritte Ablenkplatte sich oberhalb des zweiten Platinenbereichs (22) befindet und den zweiten Luftkanal von dem ersten Luftkanal trennt, und die vierte Ablenkplatte sich unterhalb des zweiten Platinenbereichs (22) befindet und den zweiten Luftkanal von dem dritten Luftkanal trennt.

4. Kommunikationsvorrichtung nach Anspruch 3, wobei
die Platinen (62) in dem zweiten Platinenbereich (22) in Querrichtung parallel angeordnet sind, die Lufteinlasslöcher (62-1) des zweiten Platinenbereichs (22) in der Mitte der Platine (62) des zweiten Platinenbereichs (22) vorgesehen sind, Belüftungsräume an zwei Seiten des zweiten Platinenbereichs (22) vorgesehen sind, eine erste Trennwand (34) an einer Oberseite des zweiten Platinenbereichs (22) vorgesehen ist, eine zweite Trennwand (35) an einer Unterseite des zweiten Platinenbereichs (22) vorgesehen ist, jede der ersten Trennwand (34) und der zweiten Trennwand (35) an zwei den Belüftungsräumen entsprechenden Seiten mit Belüftungslöchern (6) versehen ist, die erste Trennwand (34), die dritte Ablenkplatte und die Wandflächen des Gehäuses (1) einen Luftablasskanal (21-1) des zweiten Luftkanals bilden und die zweite Trennwand (35), die vierte Ablenkplatte und die Wandflächen des Gehäuses (1) einen weiteren Luftablasskanal (21-2) des zweiten Luftkanals bilden.

5. Kommunikationsvorrichtung nach Anspruch 4, wobei
die Belüftungsräume an den beiden Seiten des zweiten Platinenbereichs (22) über Belüftungslöcher (5), die an zwei Seiten der Platinen (62) in dem zweiten Platinenbereich (22) geöffnet sind, miteinander in Verbindung stehen.

6. Kommunikationsvorrichtung nach Anspruch 3, wobei
die Platinen (62) in dem zweiten Platinenbereich (22) in Querrichtung parallel angeordnet sind, die Lufteinlasslöcher (62-1) des zweiten Platinenbereichs (22) in der Mitte der Platine (62) des zweiten Platinenbereichs (22) vorgesehen sind, die dritte Ablenkplatte die erste Trennwand (34) an der Oberseite des zweiten Platinenbereichs (22) ist, die vierte Ablenkplatte die zweite Trennwand (35) an der Unterseite des zweiten Platinenbereichs (22) ist, zwischen jeweils zwei Seiten des zweiten Platinenbereichs (22) und einer jeweiligen der zwei Seitenwandflächen des Gehäuses (1) Belüftungsräume vorgesehen sind und zwei Belüftungslöcher (82) an zwei Seiten einer Rückplatte (8) des zweiten Platinenbereichs (22) vorgesehen sind, die den zwei Belüftungsräumen entsprechen.

7. Kommunikationsvorrichtung nach Anspruch 1, wobei
der Zwischenschicht-Luftkanal (2) durch Rückplatten (31, 32, 33) des ersten Platinenbereichs (21), des zweiten Platinenbereichs (22) und des dritten Platinenbereichs (23), eine hinter den Rückplatten (31, 32, 33) vorgesehene dritte Trennwand (36) und zwei Seitenwandflächen des Gehäuses (1) gebildet wird; und
die Rückplatten (31, 32, 33) des ersten Platinenbereichs (21), des zweiten Platinenbereichs (22) und des dritten Platinenbereichs (23) separat vorgesehen sind und der Zwischenschicht-Luftkanal (2) und der zweite Luftkanal durch Lücken zwischen unterschiedlichen Rückplatten (31, 32, 33) miteinander in Verbindung stehen; oder die Rückplatten des ersten Platinenbereichs (21), des zweiten Platinenbereichs (22) und des dritten Platinenbereichs (23) eine integrale Rückplatte (7) sind und der Zwischenschicht-Luftkanal (2) und der zweite Luftkanal durch ein Durchgangsloch (71, 72), das in der integralen Rückplatte (7) geöffnet ist, miteinander in Verbindung stehen.

8. Kommunikationsvorrichtung nach Anspruch 1, wobei
das erste Luftkühlmodul (41) an einem oberen Abschnitt hinter dem Zwischenschicht-Luftkanal (2) vorgesehen ist und das zweite Luftkühlmodul (42) an einem unteren Abschnitt hinter dem Zwischenschicht-Luftkanal (2) vorgesehen ist, und der Systemluftablasskanal (12-2, 12-3) sich hinter dem Zwischenschicht-Luftkanal (2) und zwischen dem ersten Luftkühlmodul (41) und dem zweiten Luftkühlmodul (42) befindet und durch eine Luftleitplatte (53) in einen ersten Luftablasskanal (12-2) und einen zweiten Luftablasskanal (12-3) unterteilt ist; oder
das erste Luftkühlmodul (41') oberhalb des ersten Luftmischkanals (3) vorgesehen ist und das zweite Luftkühlmodul (42') an einem unteren Abschnitt hinter dem Zwischenschicht-Luftkanal (2) vorgesehen ist, der Systemluftablasskanal (12-2', 12-3') einen ersten Luftablasskanal (12-2'), der sich oberhalb des ersten Luftkühlmoduls (41') befindet, und einen zweiten Luftablasskanal (12-3'), der sich hinter dem Zwischenschicht-Luftkanal (2) befindet, umfasst, und der zweite Luftablasskanal (12-3') und der erste Luftmischkanal (3) durch eine Luftleitplatte (53') getrennt sind.

9. Kommunikationsvorrichtung nach Anspruch 8, wobei
der erste Luftablasskanal (12-2, 12-2') und der zweite Luftablasskanal (12-3, 12-3') jeweils über entsprechende Luftablasslöcher (12-1) in einer Rückfläche des Gehäuses (1) mit der Außenseite in Verbindung stehen.

10. Kommunikationsvorrichtung nach Anspruch 1, wobei
der zweite Platinenbereich (22) in der Mitte der Vorrichtung einen Platinenbereich umfasst; oder
der zweite Platinenbereich (22) in der Mitte der Vorrichtung eine Vielzahl von Platinenbereichen umfasst und Luftkanäle der Vielzahl von Platinenbereichen miteinander in Verbindung stehen oder voneinander getrennt sind.

11. Kommunikationsvorrichtung nach Anspruch 1, wobei
ein schallabsorbierendes Material an einer Wandfläche von mindestens einem von dem ersten Luftmischkanal (3), dem zweiten Luftmischkanal (4) oder dem Systemluftablasskanal (12-2, 12-3, 12-2', 12-3') vorgesehen ist.

## Revendications

1. Dispositif de communication comprenant une coque (1), la coque comprenant :
une première zone de carte (21), une deuxième zone de carte (22) et une troisième zone de carte (23), dans lequel la première zone de carte (21), la deuxième zone de carte (22) et la troisième zone de carte (23) sont disposées séquentiellement dans la coque (1) de haut en bas et sont chacune pourvues d'un canal d'air indépendant ;
un canal d'air intercouche (2) en communication avec le canal d'air de la deuxième zone de carte (22), dans lequel le canal d'air intercouche (2) est prévu derrière la première zone de carte (21), la deuxième zone de carte (22) et la troisième zone de carte (23) ;
des trous d'admission d'air (11-1, 11-2, 62-1) prévus séparément dans une surface avant (11) de la coque (1) pour la première zone de carte (21), la deuxième zone de carte (22) et la troisième zone de carte (23), dans lesquels le canal d'air de la première zone de carte (21) comprend un premier canal d'air (21-1) en communication avec les trous d'admission d'air (11-1) de la première zone de carte (21), le canal d'air de la deuxième zone de carte (22) comprend un deuxième canal d'air (22-1, 22-2) en communication avec les trous d'admission d'air (62-1) de la deuxième zone de carte (22), le canal d'air de la troisième zone de carte (23) comprend un troisième canal d'air (23-1) en communication avec les trous d'admission d'air (11-2) de la troisième zone de carte (23), et le premier canal d'air, le deuxième canal d'air et le troisième canal d'air sont indépendants les uns des autres ;
un premier canal de mélange d'air (3, 3') situé au-dessus de la première zone de carte (21) et en communication avec le premier canal d'air (21-1) ; dans lequel le deuxième canal d'air (22-1, 22-2) est en communication avec le premier canal de mélange d'air (3, 3') via le canal d'air intercouche (2), et
dans lequel le premier canal de mélange d'air (3, 3') est en communication avec un canal d'évacuation d'air de système (12-2, 12-2') via un premier module de refroidissement d'air (41, 41')
**caractérisé en ce que**
un deuxième canal de mélange d'air (4) est prévu dans la coque (1) en dessous de la troisième zone de carte (23) et en communication avec le troisième canal d'air (23-1) ;
le deuxième canal d'air (22-1, 22-2) est en communication avec le deuxième canal de mélange d'air (4) via le canal d'air intercouche (2), dans lequel le canal d'air intercouche (2) est configuré pour guider l'air évacué du deuxième canal d'air (22-1, 22-2) de la deuxième zone de carte (22) dans deux flux d'air séparés (22-1, 22-2) vers le premier canal de mélange d'air (3) au-dessus de la première zone de carte (21) et le deuxième canal de mélange d'air (4) en dessous de la troisième zone de carte (23) ; et
le deuxième canal de mélange d'air (4) est en communication avec le canal d'évacuation d'air de système (12-3, 12-3') via un deuxième module de refroidissement d'air (42, 42').

2. Dispositif de communication selon la revendication 1, dans lequel
cartes (61) dans la première zone de carte (21) sont disposées longitudinalement en parallèle, les trous d'admission d'air (11-1) de la première zone de carte (21) sont prévus dans la surface avant (11) de la coque (1) entre la première zone de carte (21) et la deuxième zone de carte (22), le premier canal d'air comprend un canal d'admission d'air (21-1) formé par la première zone de carte (21), deux surfaces de paroi latérale de la coque (1) et un premier déflecteur, et le premier déflecteur est situé sous la première zone de carte (21) et isole le premier canal d'air du deuxième canal d'air ; et
cartes (63) dans la troisième zone de carte (23) sont disposées longitudinalement en parallèle, les trous d'admission d'air (11-2) de la troisième zone de carte (23) sont prévus dans la surface avant (11) de la coque (1) entre la troisième zone de carte (23) et la deuxième zone de carte (22), le troisième canal d'air comprend un canal d'admission d'air (23-1) formé par la troisième zone de carte (23), les deux surfaces de paroi latérale de la coque (1) et un deuxième déflecteur, et le deuxième déflecteur est situé au-dessus de la troisième zone de carte (23) et isole le troisième canal d'air du deuxième canal d'air.

3. Dispositif de communication selon la revendication 1, dans lequel
les trous d'admission d'air (62-1) de la deuxième zone de carte (22) sont prévus dans une carte (62) de la deuxième zone de carte (22), le deuxième canal d'air comprend un canal de ventilation formé par la deuxième zone de carte (22), des surfaces de paroi de la coque (1), un troisième déflecteur et un quatrième déflecteur ; et le troisième déflecteur est situé au-dessus de la deuxième zone de carte (22) et isole le deuxième canal d'air du premier canal d'air, et le quatrième déflecteur est situé au-dessous de la deuxième zone de carte (22) et isole le deuxième canal d'air du troisième canal d'air.

4. Dispositif de communication selon la revendication 3, dans lequel
cartes (62) dans la deuxième zone de carte (22) sont disposées transversalement en parallèle, les trous d'admission d'air (62-1) de la deuxième zone de carte (22) sont prévus au milieu de la carte (62) de la deuxième zone de carte (22), des espaces de ventilation sont prévus sur les deux côtés de la deuxième zone de carte (22), une première cloison (34) est prévue au sommet de la deuxième zone de carte (22), une deuxième cloison (35) est prévue au bas de la deuxième zone de carte (22), chacune de la première cloison (34) et la deuxième cloison (35) est pourvue de trous de ventilation (6) sur les deux côtés correspondant aux espaces de ventilation, la première cloison (34), le troisième déflecteur et les surfaces de paroi de la coque (1) forment un canal d'évacuation d'air (21-1) du deuxième canal d'air, et la deuxième cloison (35), le quatrième déflecteur et les surfaces de paroi de la coque (1) forment un autre canal d'évacuation d'air (21-2) du deuxième canal d'air.

5. Dispositif de communication selon la revendication 4, dans lequel
les espaces de ventilation des deux côtés de la deuxième zone de carte (22) sont en communication via des trous de ventilation (5) ouverts sur les deux côtés des cartes (62) dans la deuxième zone de carte (22).

6. Dispositif de communication selon la revendication 3, dans lequel
cartes (62) dans la deuxième zone de carte (22) sont disposées transversalement en parallèle, les trous d'admission d'air (62-1) de la deuxième zone de carte (22) sont prévus au milieu de la carte (62) de la deuxième zone de carte (22), le troisième déflecteur est la première cloison (34) au sommet de la deuxième zone de carte (22), le quatrième déflecteur est la deuxième cloison (35) au bas de la deuxième zone de carte (22), des espaces de ventilation sont prévus entre chacun des deux côtés de la deuxième zone de carte (22) et une respective des deux surfaces de paroi latérale de la coque (1), et deux trous de ventilation (82) sont prévus sur deux côtés d'une carte arrière (8) de la deuxième zone de carte (22) correspondant aux deux espaces de ventilation.

7. Dispositif de communication selon la revendication 1, dans lequel
le canal d'air intercouche (2) est formé par des cartes arrière (31, 32, 33) de la première zone de carte (21), de la deuxième zone de carte (22) et de la troisième zone de carte (23), une troisième cloison (36) prévue derrière les cartes arrière (31, 32, 33) et deux surfaces de paroi latérale de la coque (1) ; et les cartes arrière (31, 32, 33) de la première zone de carte (21), de la deuxième zone de carte (22) et de la troisième zone de carte (23) sont fournis séparément, et le canal d'air intercouche (2) et le deuxième canal d'air sont en communication les uns avec les autres à travers des espaces entre différentes cartes arrière (31, 32, 33) ; ou les cartes arrière de la première zone de carte (21), de la deuxième zone de carte (22) et de la troisième zone de carte (23) constituent une carte arrière intégrée (7), et le canal d'air intercouche (2) et le deuxième canal d'air sont en communication les uns avec les autres à travers un trou traversant (71, 72) ouvert dans la carte arrière intégrée (7).

8. Dispositif de communication selon la revendication 1, dans lequel
le premier module de refroidissement d'air (41) est prévu sur une portion supérieure derrière le canal d'air intercouche (2) et le deuxième module de refroidissement d'air (42) est prévu sur une portion inférieure derrière le canal d'air intercouche (2), et le canal d'évacuation d'air de système (12-2, 12-3) est situé derrière le canal d'air intercouche (2) et entre le premier module de refroidissement d'air (41) et le deuxième module de refroidissement d'air (42), et il est séparé par une plaque de guidage d'air (53) en un premier canal d'évacuation d'air (12-2) et un deuxième canal d'évacuation d'air (12-3) ; ou
le premier module de refroidissement d'air (41') est prévu au-dessus du premier canal de mélange d'air (3) et le deuxième module de refroidissement d'air (42') est prévu sur une portion inférieure derrière le canal d'air intercouche (2), le canal d'évacuation d'air de système (12-2', 12-3') comprend un premier canal d'évacuation d'air (12-2 ') situé au-dessus du premier module de refroidissement d'air (41') et un deuxième canal d'évacuation d'air (12-3') situé derrière le canal d'air intercouche (2), et le deuxième canal d'évacuation d'air (12-3') et le premier canal de mélange d'air (3) sont séparés par une plaque de guidage d'air (53').

9. Dispositif de communication selon la revendication 8, dans lequel
le premier canal d'évacuation d'air (12-2, 12-2') et le deuxième canal d'évacuation d'air (12-3, 12-3') sont chacun en communication avec l'extérieur via des trous d'évacuation d'air (12-1) respectifs dans une surface arrière de la coque (1).

10. Dispositif de communication selon la revendication 1, dans lequel
la deuxième zone de carte (22) au milieu du dispositif comprend une zone de carte ; ou
la deuxième zone de carte (22) au milieu du dispositif comprend une pluralité de zones de carte, et les canaux d'air de la pluralité de zones de carte sont en communication les uns avec les autres ou séparés les uns des autres.

11. Dispositif de communication selon la revendication 1, dans lequel
un matériau d'absorption acoustique est prévu sur une surface de paroi d'au moins un parmi le premier canal de mélange d'air (3), le deuxième canal de mélange d'air (4) ou le canal d'évacuation d'air de système (12-2, 12-3, 12-2', 12-3').
